# EUROPÄISCHE PATENTSCHRIFT

(11) **EP 0 444 720 B1**
(45) Veröffentlichungstag und Bekanntmachung des Hinweises auf die Patenterteilung: **14.04.1999**
(21) Anmeldenummer: 91200110.4
(22) Anmeldetag: 21.01.1991
(51) Int. Cl.: H01L 27/146, H01L 31/0224, G01T 1/00

(54) **Sensormatrix**
Sensor array
Matrice de capteurs

(30) Priorität: 27.01.1990 DE 4002429
(43) Veröffentlichungstag der Anmeldung: 04.09.1991
(73) Patentinhaber: Philips Patentverwaltung GmbH, 22335 Hamburg (DE); Koninklijke Philips Electronics N.V., 5621 BA Eindhoven (NL)
(72) Erfinder: Conrads, Norbert, B-4729 Hauset (BE); Schiebel, Ulrich, Dr., W-5100 Aachen (DE); Wieczorek, Herfried Dr., W-5100 Aachen (DE)
(74) Vertreter: von Laue, Hanns-Ulrich, Dipl.-Ing.

(56) Entgegenhaltungen:
- EP-A- 145 199
- EP-A- 558 117
- WO-A-88/00759
- US-A- 4 862 237
- PATENT ABSTRACTS OF JAPAN vol. 7, no. 228 (P-228) 08 Oktober 1983, & JP-A-58 117478 (FUJI XEROX K.K.) 13 Juli 1983
- PATENT ABSTRACTS OF JAPAN vol. 12, no. 440 (E-684)(3287) 18 November 1988, & JP-A-63 172462 (FUJITSU LTD) 16 Juli 1988
- PATENT ABSTRACTS OF JAPAN vol. 9, no. 216 (E-340)(1939) 03 September 1985, & JP-A-60 077472 (FUJI XEROX KK) 02 Mai 1985

## Beschreibung

Die Erfindung betrifft eine Sensormatrix nach dem Oberbegriff des Anspruchs 1.

Aus der europäischen Offenlegungsschrift 0 337 826 ist eine Sensormatrix bekannt, bei der die ersten Elektroden der Sensoren in einer Richtung, beispielsweise in Zeilenrichtung, und die zweiten Elektroden in einer Richtung 90° zur ersten Richtung, beispielsweise in Spaltenrichtung, durchverbunden sind. Zwischen den beiden Elektroden sind mehrere, aufeinandergeschichtete Halbleiterschichten vorgesehen. Die Röntgenstrahl-Empfindlichkeit dieser Sensormatrix wird dadurch erzielt, daß auf der äußeren Elektrode eine Leuchtschicht vorgesehen ist, welche bei Auftreffen von Röntgenstrahlung Licht emittiert, welches wiederum in den Halbleiterschichten die gewünschte Reaktion erzeugt. Röntgenstrahlung wird hier also indirekt mittels einer Leuchtschicht gemessen.

Es ist Aufgabe der Erfindung, eine Sensormatrix der eingangs genannten Art anzugeben, welche einen möglichst einfachen Aufbau aufweist. Diese Aufgabe wird erfindungsgemäß durch die im Anspruch 1 angegebenen Maßnahmen gelöst.

Jedes Sensorelement weist also eine erste Elektrode auf, welche von den ersten Elektroden aller übrigen Sensorelemente mechanisch und elektrisch getrennt ist und welche nur für das eine Sensorelement wirksam ist. Für mehrere Sensoren in der Matrix sind also für jeden Sensor nebeneinander angeordnet jeweils entsprechende Einzelelektroden als erste Elektroden vorgesehen. Diese ersten Elektroden der Sensoren sind mittels einer Halbleiterschicht abgedeckt, welche durchgehend für alle Sensoren gebildet ist, welche also nicht unterbrochen oder sonstwie unterteilt ist. Die zweiten Elektroden der Sensoren sind wiederum durch eine durchgehende Schicht gebildet, welche wenigstens für Gruppen von Sensoren gemeinsam wirksam ist. So kann z.B. für eine Gruppe von zehn Sensoren eine gemeinsame zweite Elektrode vorgesehen sein. Diese Elektrode ist dann für die zehn Sensoren einteilig. Im Extremfall kann diese zweite Elektrode für alle Sensoren der Matrix gemeinsam als eine einzige Elektrode ausgeführt sein.

Bei der Anordnung ergibt sich der Vorteil einer stark vereinfachten Fertigung. Die Halbleiterschicht und die zweite Elektrode sind als jeweils eine Schicht ausgeführt, die nicht strukturiert werden muß. Für die einzelnen Sensoren sind nur noch deren erste Elektroden, ebenso wie ein gegebenenfalls pro Sensor vorgegebenes Schaltelement, für jeden Sensor einzeln vorzusehen.

Nach einer Ausgestaltung der Erfindung ist vorgesehen, daß die zweite, als durchgehende Schicht gebildete Elektrode die Halbleiterschicht im Bereich der ersten Elektroden aller Sensoren der Matrix abdeckt und für alle Sensoren der Matrix als gemeinsame zweite Elektrode wirksam ist.

Der oben beschriebene Effekt der Fertigungsvereinfachung ist bei dieser Ausführungsform am deutlichsten, ohne daß sich dadurch funktionale Nachteile für die Sensoren ergeben.

Nach einer weiteren Ausgestaltung der Erfindung ist vorgesehen, daß für Röntgenstrahl-Empfindlichkeit der Sensoren die gemeinsam für alle Sensoren gebildete Halbleiterschicht so dick ausgeführt ist, daß sie selbst ausreichend Röntgenstrahlen absorbiert, und daß keine zusätzliche Leuchtstoffschicht vorgesehen ist.

Auch für eine Sensormatrix, deren Sensoren röntgenstrahlempfindlich sein sollen, kann der oben beschriebene einfache Aufbau dadurch beibehalten werden, daß die Halbleiterschicht so dick ausgeführt ist, daß sie selbst in gewünschtem Maße Röntgenstrahlen absorbiert und auf diese Weise beispielsweise eine zu messende Ladungsverschiebung ausgelöst wird. Es ist in diesem Falle keine zusätzliche Leuchtstoffschicht erforderlich.

Die gewünschte Röntgenstrahl-Empfindlichkeit der Halbleiterschicht kann, wie nach einer weiteren Ausgestaltung der Erfindung vorgesehen ist, vorteilhafterweise mittels eines geeignet dotierten Selens erzeugt werden, daß in einer Dicke von etwa 0,5 mm vorzusehen ist.

Anhand der Zeichnung wird ein Ausführungsbeispiel der Figur näher erläutert. Es zeigen:
Fig. 1 ein schematisiertes Schaltbild eines Ausschnittes einer Sensormatrix mit einer für alle Sensoren der Matrix gemeinsam vorgesehenen zweiten Elektrode und
Fig. 2 eine Aufsicht auf einen Ausschnitt einer Matrix mit einer für alle Sensoren gemeinsamen zweiten Elektrode.

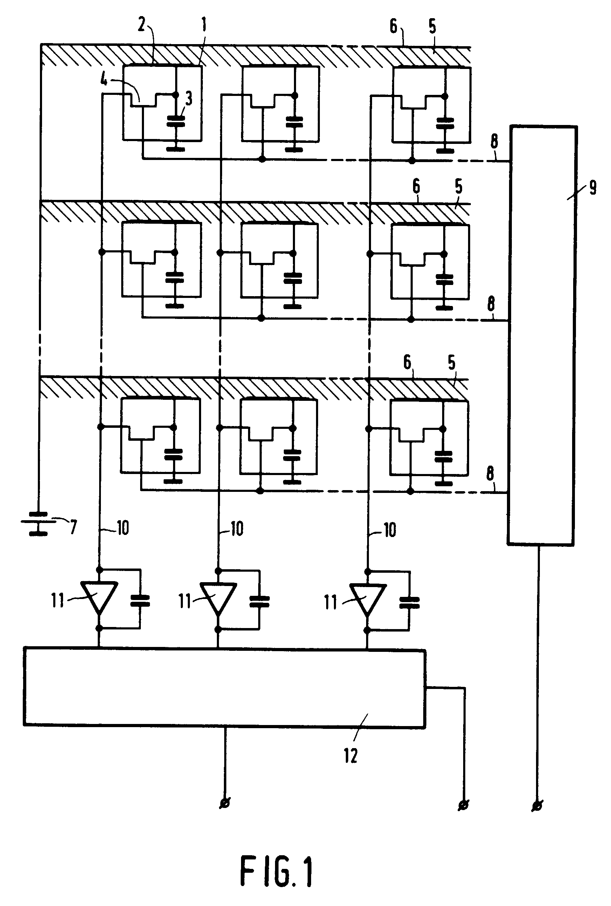

Ein in Fig. 1 dargestelltes Prinzipschaltbild einer Sensormatrix, bei der für alle Sensorelemente der Matrix eine gemeinsame Halbleiterschicht und ebenso eine gemeinsame zweite Elektrode vorgesehen sind, zeigt Sensoren 1, welche in Zeilen und Spalten in der Matrix angeordnet sind. Die einzelnen Sensoren 1 der Matrix sind in identischer Weise aufgebaut. Jeder Sensor 1 weist eine erste Elektrode 2 auf, welche nur im Bereich des jeweiligen Sensors 1 vorgesehen ist, und welche von den ersten Elektroden 2 der benachbarten Sensoren 1 mechanisch und elektrisch getrennt ist. Jede der ersten Elektroden 2 ist in dem jeweiligen Sensor 1 mit einer ersten Elektrode einer Speicherkapazität 3 verbunden, deren andere Elektrode auf Masse geführt ist. Die Verbindung zwischen der ersten Elektrode 2 und der Speicherkapazität 3 ist mit einem Source-Anschluß eines Feldeffekttransistors 4 verbunden.

In einer Sensormatrix können beispielsweise 2000 x 2000 derartige Sensoren vorgesehen sein. Die Darstellung gemäß Fig. 1 berücksichtigt jedoch zur Verdeutlichung nur drei Sensoren pro Zeile und Spalte.

Alle Sensoren der Matrix sind, wie in der Fig. 1 schematisch angedeutet ist, mittels einer Halbleiterschicht 5 abgedeckt, welche wenigstens alle ersten Elektroden 2 aller Sensorelemente 1 der Matrix abdeckt.

Die Halbleiterschicht 5 ihrerseits wiederum ist mittels einer elektrisch leitfähigen Schicht 6 abgedeckt, welche als zweite Elektrode dient, die für alle Sensoren 1 der Matrix als solche wirksam ist. Die zweite Elektrode 6 ist mit einer Gleichspannungsquelle 7 verbunden, deren anderer Pol auf Masse geführt ist.

Die in Fig. 1 schematisch dargestellte Sensormatrix ist in Dünnschichttechnik hergestellt. Dies gilt nicht nur für die beiden Elektroden sowie die Halbleiterschicht, sondern auch für die Speicherkapazitäten 3 und die Feldeffekttransistoren 4.

Die für alle Sensoren der Matrix gemeinsame zweite Elektrode 6 ist mittels der Gleichspannungsquelle 7 vorgespannt. Trifft auf die Halbleiterschicht 5 Licht- bzw. Röntgenstrahlung, so wird diese von der Halbleiterschicht absorbiert und verändert ihre Leitfähigkeit. Es findet damit eine Ladungsverschiebung statt, welche dazu führt, daß die Speicherkapazitäten 3 der Sensoren 1 elektrisch aufgeladen werden. Die Höhe der Aufladung jedes einzelnen Sensors hängt davon ab, wieviel Strahlung auf die Halbleiterschicht 5 im Bereich zwischen der ersten Elektrode 2 dieses Sensors und der Gegenelektrode 6 in einem bestimmten Zeitabschnitt aufgetroffen ist.

Die in den Speicherkapazitäten 3 gespeicherten Ladungen können zur Bestimmung der aufgetroffenen Strahlung ausgelesen werden. Dazu ist für jede Zeile der Sensoren je eine Schaltleitung 8 vorgesehen, welche mit den Gate-Anschlüssen der Feldeffekttransistoren der Sensoren ihrer Zeile verbunden sind und welche mittels einer Ansteuerschaltung 9 ansteuerbar sind. Die Ansteuerschaltung 9 kann beispielsweise die Schaltleitung 8 der ersten Zeile aktivieren, so daß alle Feldeffekttransistoren 4 der Sensoren dieser Zeile leitend geschaltet werden. Die in den Sensoren dieser Zeile gespeicherten Ladungen werden dann über je Sensorenspalte eine mit den Drain-Anschlüssen der Feldeffekttransistoren der Sensoren ihrer Spalte verbundene Ausleseleitung 10 ausgelesen. Es findet also ein Auslesen statt, welches für alle Sensoren dieser Zeile gleichzeitig erfolgt. Nach Verstärkung der so ausgelesenen Signale in Verstärkern 11 gelangen diese in verstärkter Form in eine Multiplexschaltung 12, welche aus den parallel eingehenden Daten der Sensorenspalten ein serielles Ausgangssignal formt.

In Fig. 1 sind zur möglichst übersichtlichen Darstellung des elektrischen Schaltprinzips sowohl die Halbleiterschicht 5, wie auch die gemeinsame zweite Elektrode 6 mehrteilig dargestellt. Tatsächlich sind jedoch beide jeweils einteilig hergestellt und überdecken sämtliche erste Elektroden 2 aller Sensoren 1 der Matrix.

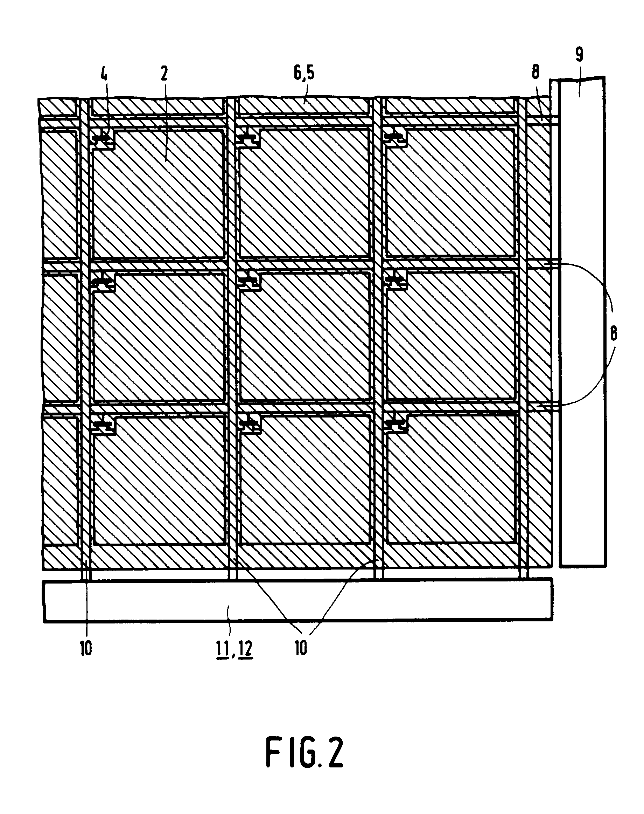

Dieser Sachverhalt ist in der Darstellung gemäß Fig. 2 noch deutlicher zu erkennen, die eine Aufsicht auf ein Teil einer erfindungsgemäßen Matrix zeigt. Die Matrix ist in Aufsicht auf die gemeinsame zweite Gegenelektrode 6 dargestellt. Sowohl die Gegenelektrode 6 wie auch die gemeinsame Halbleiterschicht 5 überdecken alle erste Elektroden 2 der Sensoren der Matrix, von denen in der Fig. 2 exemplarisch nur neun dargestellt sind. Um die darunterliegenden Elemente der Sensoren darstellen zu können, sind in der Darstellung gemäß Fig. 2 die zweite Elektrode 6 und die Halbleiterschicht 5 nur in Schraffur und quasi transparent dargestellt.

Unterhalb der Ebene der Halbleiterschicht 5 ist in der Darstellung gemäß Fig. 2 für jeden Sensor eine erste Elektrode 2 erkennbar, welche eine relativ große Fläche einnimmt. Die Speicherkapazitäten 3 sind in Fig. 2 der besseren Erkenntlichkeit halber weggelassen. Die ersten Elektroden 2 der Sensoren sind daher in der Darstellung gemäß Fig. 2 direkt mit den Source-Anschlüssen der Feldeffekttransistoren 4 verbunden. Die Gate-Anschlüsse der Feldeffekttransistoren 4 sind jeweils mit einer Schaltleitung 8 verbunden, während die Drain-Anschlüsse der Feldeffekttransistoren jeweils mit einer Ausleseleitung 10 verbunden sind.

Die Anordnung gemäß Fig. 2 ist in Dünnfilmtechnik hergestellt. Dies gilt für sämtliche Elemente der Sensoren, also auch für die Feldeffekttransistoren 4 sowie für die für jeden Sensor einzeln vorgesehenen ersten Elektroden 2. Ebenfalls in Dünnschichttechnik hergestellt sind sowohl die alle ersten Elektroden der Sensoren überdeckende Halbleiterschicht wie auch die auf dieser vorgesehene elektrisch leitfähige Schicht 6, welche für alle Sensoren der Matrix als gemeinsame zweite Elektrode dient.

Aus der Darstellung gemäß Fig. 2 wird deutlich, daß die Struktur der Matrix aufgrund der gemeinsam vorgesehenen Schichten 5 und 6 relativ einfach ist und daß für jeden einzelnen Sensor individuell nur noch jeweils eine erste Elektrode 2 und ein Feldeffekttransistor 4 vorzusehen sind. Aufgrund dieser einfachen Struktur ist eine solche Matrix einfach und mit geringem Ausschuß zu fertigen.

Ohne den Fertigungsprozeß wesentlich zu verkomplizieren, besteht die Möglichkeit, die zweite Elektrode 6 großflächig zu segmentieren, d.h. eine gemeinsame durchgehende Schicht nur für eine Gruppe von Sensoren vorzusehen. So kann beispielsweise für eine Gruppe von 100 x 100 Sensoren eine gemeinsame Gegenelektrode 6 vorgesehen sein. Entsprechendes gilt dann für weitere Gruppen von Sensoren, die ihrerseits wiederum eine für sie vorgesehene, gemeinsame zweite Elektrode 6 aufweisen. Eine solche Gruppe von Sensoren kann beispielsweise auch von allen Sensoren einer Spalte oder Zeile gebildet werden.

## Patentansprüche

1. Sensormatrix mit in Dünnschichttechnik erzeugten, in Zeilen und Spalten angeordneten, licht- und/oder röntgenstrahlenempfindlichen Sensoren (1), welche zwei Elektroden (2,6) und eine zwischen diesen angeordnete Halbleiterschicht (5) aufweisen,
dadurch gekennzeichnet, daß
- jeder Sensor (1) jeweils eine Einzelelektrode als erste Elektrode (2) sowie ein Schaltelement (4) umfaßt,
- die ersten Elektroden (2) der Sensoren einer Spalte bzw. Zeile über die Schaltelemente (4) mit einer gemeinsamen Ausleseleitung (10) verbunden sind,
- die Schaltelemente einer Zeile bzw. Spalte an eine gemeinsame Schaltleitung (8) zum Schalten der Schaltelemente (4) angeschlossen sind,
- die Halbleiterschicht (5) durchgehend für alle Sensoren (1) als gemeinsame Schicht gebildet ist und alle ersten Elektroden (2) abdeckt und
- die zweite Elektrode (6) wenigstens für Gruppen der Sensoren (1) als eine durchgehende Schicht (6) gebildet ist, die jeweils die Halbleiterschicht (5) im Bereich aller ersten Elektroden (2) der Sensoren ihrer Gruppe abdeckt und für alle Sensoren ihrer Gruppe als zweite Elektrode wirksam ist.

2. Sensormatrix nach Anspruch 1,
dadurch gekennzeichnet, daß die zweite, als durchgehende Schicht gebildete Elektrode die Halbleiterschicht (5) im Bereich der ersten Elektroden (2) aller Sensoren (1) der Matrix abdeckt und für alle Sensoren (1) der Matrix als gemeinsame zweite Elektrode (6) wirksam ist.

3. Sensormatrix nach Anspruch 1 oder 2,
dadurch gekennzeichnet, daß für Röntgenstrahl-Empfindlichkeit der Sensoren die gemeinsam für alle Sensoren (1) gebildete Halbleiterschicht so dick ausgeführt ist, daß sie selbst ausreichend Röntgenstrahlen absorbiert, und daß keine zusätzliche Leuchtstoffschicht vorgesehen ist.

4. Sensormatrix nach Anspruch 3,
dadurch gekennzeichnet, daß als Halbleitermaterial (5) geeignet dotiertes Selen vorgesehen ist und daß die Halbleiterschicht eine Dicke von etwa 0,5 mm aufweist.

## Claims

1. A sensor matrix comprising light-sensitive and/or X-ray sensitive thin-film sensors (1) which are arranged in rows and columns and comprise two electrodes (2, 6) and a semiconductor layer (5) arranged therebetween, characterized in that
- each sensor (1) comprises a respective separate electrode as the first electrode (2) as well as a switching element (4),
- the first electrodes (2) of the sensors of a column or row are connected to a common read line (10) via the switching elements (4),
- the switching elements of a row or column are connected to a common switching line (8) for the switching of the switching elements (4),
- the semiconductor layer (5) is formed as a continuous layer which is common to all sensors (1) and covers all first electrodes (2), and
- the second electrode (6) is formed, at least for groups of sensors (1), as a continuous layer (6) which covers the semiconductor layer (5) at the area of all first electrodes (2) of the sensors of the relevant group and acts as the second electrode for all sensors of the relevant group.

2. A sensor matrix as claimed in Claim 1, characterised in that the second electrode, being formed as a continuous layer, covers the semiconductor layer (5) at the area of the first electrodes (2) of the sensors (1) of the matrix and acts as a common second electrode (6) for all sensors (1) of the matrix.

3. A sensor matrix as claimed in claim 1 or 2, characterized in that for X-ray sensitivity of the sensors the semiconductor layer common to all sensors (1) is constructed to be so thick that the layer itself absorbs an adequate amount of X-rays, and that no additional luminescent layer is provided.

4. A sensor matrix as claimed in Claim 3, characterized in that suitably doped selenium is used as the semiconductor material (5), and that the semiconductor layer has a thickness of approximately 0.5 mm.

## Revendications

1. Matrice de capteurs avec des capteurs (1) sensibles au rayonnement lumineux et/ou au rayonnement X disposés en colonnes et en lignes et fabriqués dans une technique à couche mince qui présente deux électrodes (2, 6) et une couche de semi-conducteurs (5) disposée entre celles-ci,
caractérisée en ce que:
- chaque capteur (1) comprend respectivement une électrode individuelle comme première électrode (2) ainsi qu'un élément de commutation (4),
- les premières électrodes (2) des capteurs d'une colonne ou ligne sont reliées par l'intermédiaire des éléments de commutation (4) avec une conduite de lecture (10) commune,
- les éléments de commutation d'une ligne ou colonne sont reliés à une conduite de commutation commune (8) en vue de la commutation des éléments de commutation (4),
- la couche de semi-conducteurs (5) est formée en continu comme une couche collective pour tous les capteurs (1) et recouvre toutes les premières électrodes (2) et
- la deuxième électrode (6) est formée comme une couche continue (6) au moins pour des groupes de capteurs (1), couche qui recouvre respectivement la couche de semi-conducteurs (5) dans la zone de toutes les premières électrodes (2) des capteurs de son groupe et est active comme deuxième électrode pour tous les capteurs de son groupe.

2. Matrice de capteurs selon la revendication 1,
caractérisée en ce que la deuxième électrode formée comme une couche continue recouvre la couche de semi-conducteurs (5) dans la zone des premières électrodes (2) de tous les capteurs (1) de la matrice et est active comme une deuxième électrode collective (6) pour tous les capteurs (1) de la matrice.

3. Matrice de capteurs selon l'une des revendications 1 ou 2,
caractérisée en ce que la couche de semi-conducteurs collective pour tous les capteurs (1) est de conception si épaisse pour la sensibilité aux rayons X des capteurs qu'elle absorbe elle-même une quantité suffisante de rayons X et qu'aucune couche luminescente supplémentaire n'est prévue.

4. Matrice de capteurs selon la revendication 3,
caractérisée en ce que du sélénium doté adéquatement est prévu comme matériau semiconducteur (5) et que la couche de semi-conducteurs présente une épaisseur d'environ 0,5 mm.
